# EUROPÄISCHE PATENTSCHRIFT

(11) **EP 0 469 172 B1**
(45) Veröffentlichungstag und Bekanntmachung des Hinweises auf die Patenterteilung: **25.01.1995**
(21) Anmeldenummer: 90114824.7
(22) Anmeldetag: 02.08.1990
(51) Int. Cl.: H02M 1/088, H03K 17/12

(54) **Viertelbrückenschaltung für grosse Ströme**
Quarter bridge circuit for high currents
Circuit d'un quart de pont pour courants forts

(43) Veröffentlichungstag der Anmeldung: 05.02.1992
(73) Patentinhaber: ASEA BROWN BOVERI AG, 5400 Baden (CH)
(72) Erfinder: Grüning, Horst, Dr., CH-5404 Baden (CH)

(56) Entgegenhaltungen:
- EP-A- 0 039 279
- EP-A- 0 185 181
- EP-A- 0 260 471
- DE-A- 3 322 641
- PATENT ABSTRACTS OF JAPAN vol. 10, no. 275 (E-438)(2331) 18 September 1986
- & JP-A-61 95610 (FUJI) 14 Mai 1986,

## Beschreibung

### Technisches Gebiet

Die Erfindung betrifft eine Viertelbrückenschaltung für grosse Ströme, umfassend mehrere, über jeweils ein Gate abschaltbare Halbleiterbauelemente und je eine, bezüglich eines Mittelpunktes gegenüberliegende Freilaufdiode, so dass ein Gesamtstrom in der Viertelbrückenschaltung auf mehrere parallele Strompfade aufgeteilt ist.

### Stand der Technik

Die intensive Forschung auf dem Gebiet der Leistungselektronik hat eine grosse Zahl verschiedenartiger Bauelementtypen hervorgebracht. Von besonderem Interesse sind dabei diejenigen neuen Schalter, die eine leistungsarme und schnelle Ansteuerung erlauben. Bisher stehen aber zum Abschalten von hohen Strömen für den Anwender nach wie vor nur solche Bauelemente zur Verfügung, die eine aufwendige Snubberbeschaltung benötigen (z.B. GTO).

Die Weiterentwicklung der bekannten, anwenderfreundlichen, feinstrukturierten Bauelemente in Richtung hoher Schaltleistungen birgt eine Anzahl von Unwägbarkeiten und Kostenfaktoren in sich:
1. Grössere Leistungen bedingen grössere Chipflächen und entsprechend grössere Kontaktflächen. Die Probleme, die sich bei der (für grossfläche Bauelemente nötigen) Druckkontaktierung feinster Strukturen stellen, sind nicht überschaubar.
2. Gehäuse und Einspannsystem sind für grosse Bauelemente aufwendig und teuer.
3. Der Einbau der notwendigen, niederinduktiven Ansteuerung ins Druckkontaktgehäuse ist problematisch.
4. Mit zunehmender Stromstärke im Kreis steigt die Gefahr einer unerwünschten elektromagnetischen Interferenz (EMI = Electro Magnetic Interference).
5. Streuinduktivitäten im Lastkreis können mit dem Reverse Recovery der Dioden grosse Ueberspannungsspitzen bewirken.
6. Eine Vergrösserung der Halbleiterschalter hat bei der Herstellung eine Verminderung der Ausbeute zur Folge. Mit der sog. Wafer-Repair Technologie kann dieser Nachteil nur zum Teil eliminiert werden.

An Versuchen, diese Probleme zu überwinden mangelt es nicht, besteht doch anwenderseitig seit langem der Wunsch, hohe Leistungen mit geringem Schaltungsaufwand steuern zu können.

Bei der ganzen Problematik leistungsfähiger Halbleiterbauelemente darf aber nicht vergessen werden, dass dem Anwender ein Modul zur Verfügung stehen muss, in welchem das gewünschte Schaltelement (Halbleiterchip) möglichst verwendungsfreundlich verpackt ist. Es ist somit nicht damit getan, einen Halbleiterschalter für hohe Ströme zur Verfügung zu stellen. Vielmehr sollte der Leistungshalbleiter im Hinblick auf eine vorteilhafte Modulkonstruktion entwickelt werden. Dabei müssen die im entsprechenden Leistungsbereich wichtigsten Schaltanordnungen im Auge behalten werden. Dazu gehören z.B. Brückenschaltungen für Inverter, Chopperschaltungen u.dgl.

Aus dem Bericht "Abschaltbare Elemente der Leistungselektronik und ihre Anwendungen", Friedrich Speth, ETG Fachtagung 4./5. Mai 1988, ETG-Fachbericht 23, 305-314, ist die Verwendung von Transistor-Modulen bekannt, welche neben dem abschaltbaren Halbleiterbauelement eine Freilaufdiode umfassen. Es ist das Ziel der Verschaltung, die Induktivitäten möglichst klein zu halten.

Zur Erweiterung des Leistungsbereichs wird ausserdem vorgeschlagen, mehrere gleiche Transistor-Module parallel zu schalten. Dabei ist es beispielsweise vorteilhaft, Emitter, Kollektor und Basis durch je eine niederinduktive Stromschiene zu verbinden.

Bei GTOs ist die Situation völlig anders. Sie werden nicht parallel geschaltet, weil die Gefahr besteht, dass bei geringsten Schaltverzögerungen einzelner Bauelemente, der Strom in den übrigen zu gross wird. Probleme mit dem Ueberstrom können aber schon in konventionellen dreiphasigen Umrichtern auftreten, wenn z.B. die elektronischen Ueberstromschutzorgane versagen. Für diesen Fall wird in der genannten Veröffentlichung vorgeschlagen, in der Versorgungsleitung eine Sicherung vorzusehen, die beim Auftreten eines Fehlers in einem Zweig durch gezieltes Zünden der übrigen Zweige durchgebrannt wird. Der grosse Nachteil dieser Massnahme besteht darin, dass gleich der ganze Umrichter ausser Gefecht gesetzt wird.

In der europäischen Patentanmeldung EP 0 185 181 wird nun versucht, die Streuinduktivitäten von Schaltungsdioden, - Kondensatoren und Leitungsanschlüssen des Abschaltentlastungskreises eines Leistungsthyristors dadurch zu erniedrigen, dass die Elemente gleiche Bauelement-Achsrichtungen aufweisen. Sie sind also achsparallel oder koaxial zueinander angeordnet. Elektrisch sind diese Bauelemente mittels im wesentlichen parallel zueinander verlaufenden, elektrisch leitenden Platten und symmetrischen, glockenförmigen Kappen oder Drahtanschlüssen zwischen den Platten und den Anschlussklemmen der Bauelemente verbunden.

Aus der Veröffentlichung "High Voltage GTO Inverter Using Reverse Conducting GTO-Thyristor", H. Saotome und S. Konishic, ist eine Inverterschaltung mit in Serie geschalteten GTOs bekannt. Zur Verminderung der Belastung der GTOs sind in der Zuleitung sättigende Induktivitäten vorgesehen.

### Darstellung der Erfindung

Aufgabe der Erfindung ist es nun, eine Viertelbrückenschaltung der eingangs genannten Art anzugeben, die bei hohem Laststrom eine hohe Betriebssicherheit zulässt und mit möglichst geringem Aufwand zu realisieren ist.

Erfindungsgemäss besteht die Lösung darin, dass
a) für jeden Strompfad im wesentlichen ein zugeordneter Clamping-Kondensator parallel zu Freilaufdiode und abschaltbarem Halbleiterbauelement so angeordnet ist, dass der jeweilige Freilaufpfad insgesamt eine möglichst minimale Induktivität aufweist, und
b) zwischen einem Lastanschluss der Viertelbrückenschaltung und jedem Mittelpunkt der Strompfade je eine die Stromanstiegsgeschwindigkeit begrenzende Induktivität vorgesehen ist, so dass ein durch eine Schaltverzögerung bedingter Stromstoss das abschaltbare Halbleiterbauelement nicht überlastet.

Der Kern der Erfindung besteht darin, dass der gesamte Strom nicht von einem grossen, sondern von mehreren, kleineren, in geeigneter Weise parallel angeordneten Leistungsbauelementen geschaltet wird und dass gleichzeitig die parallelen Freilaufpfade mit einer minimalen Induktivität behaftete sind. Jeder Strompfad verfügt ausserdem über eine eigene Freilaufdiode und einen zumindest zugeordneten, vorzugsweise aber eigenen di/dt-Clamp. Die die Stromanstiegsgeschwindigkeit begrenzende Induktivität gewährleistet den sicheren Betrieb trotz unvermeidlicher Asynchronitäten beim Schalten.

Der Vorteil der erfindungsgemässen Anordnung liegt darin, dass im Vergleich zum Stand der Technik deutlich kleinere Ueberspannungen auftreten. Dadurch, dass die Chips (Halbleiterbauelemente, Keramikkondensatoren) kleiner sind als beim Hochstromaufbau, wird die Schleife pro Baugruppe kleiner. Zugleich teilt sich der Strom auf mehrere Pfade (Baugruppen) auf, so dass in den einzelnen (im Endeffekt unvermeidbaren) Schlaufen weniger Strom fliesst.

Vorzugsweise nehmen die genannten Induktivitäten auch die Funktion einer Kurzschlussicherung wahr. In diesem Fall ist die Induktivität jeweils so bemessen, dass bei einem Kurzschluss der Strom innerhalb der durch die Detektionszeit und die Schaltverzögerung gegebenen Zeitspanne den maximal abschaltbaren Strom nicht überschreitet. Damit kann auf eine separate, externe Kurzschlusssicherung verzichtet werden. Die integrierte Kurzschlussicherung kann also schnell und zielgerecht reagieren.

Eine weitere vorteilhafte Massnahme besteht darin, in jedem Strompfad zwischen Mittelpunkt und Lastanschluss eine herkömmliche Sicherung (engl. fuse) vorzusehen. Wenn nämlich ein Halbleiterschalter aus irgendwelchen Gründen defekt wird und entsprechend seine Sperrfähigkeit verliert, dann brennt die zugehörige Schmelzsicherung durch und eliminiert damit den defekten Strompfad. Die gesamte Schaltanordnung kann aber wegen der in der Praxis vorgesehenen Redundanz nach wie vor die gewünschte Funktion ausüben.

Eine besonders einfache Ansteuerung der Brückenschaltung ergibt sich, wenn die zum selben Viertelbrückenzweig gehörenden abschaltbaren Halbleiterbauelemente von einer bezüglich des jeweiligen Gates potentialgetrennten, gemeinsamen Gate-Unit angesteuert sind.

Zum Gewährleisten einer ausgeglichenen statischen Stromverteilung in den parallelen Strompfaden kann z.B. je in Serie zu der strombegrenzenden Induktivität ein Widerstand vorgesehen sein. Sein Wert ist so bemessen, dass bei Vollast ein Spannungsabfall von 0.1 bis 1 V, vorzugsweise 0.2 bis 0.5 V, resultiert.

Der Widerstand wird vorzugsweise zumindest teilweise durch eine Sicherung gebildet. Damit kann im Fall eines Defektes in einem Strompfad der Totalausfall der Anordnung vermieden werden.

Die Erfindung eignet sich insbesondere auch im Zusammenhang mit der aus der Veröffentlichung EP 0 260 471 bekannten Kaskodeschaltung, bei der zwischen Gate und Kathode des Hochleistungs-Bipolarelements (GTO, FSGTO, FCTh etc.) mindestens ein MOSFET, eine Zenerdiode und eine zur Diode parallele Kapazität vorgesehen sind. Der Widerstand zur statischen Stromverteilung wird dabei durch den Kanal des Niederspannungs-MOSFETs (d.h. dessen Widerstand und Temperaturabhängigkeit) gebildet. Der MOSFET nimmt also gleich zwei Funktionen wahr. Ferner kann die Kaskodeschaltung wegen der relativ kleinen Leistung pro Strompfad wirtschaftlich eingesetzt werden, d.h. es genügen relativ kleine MOSFETs.

Eine besonders einfache Ueberwachung der Brückenschaltung ergibt sich, wenn zum Detektieren der Belastung eines abschaltbaren Halbleiterbauelements Mittel vorgesehen sind, die die an der jeweiligen Induktivität anliegende Spannung messen. Diese Ueberwachung findet in unmittelbarer Nähe des Leistungsschalters statt und lässt sich mit geringem Aufwand realisieren.

Als abschaltbare Halbleiterbauelemente werden in der Erfindung vorzugsweise FCThs (Field Controlled Thyristor) resp. CFCThs (Complementary Field Controlled Thyristor) eingesetzt. Diese nicht strombegrenzenden Bauelemente können sehr schnell (hart) angesteuert werden. Die aufwendigen Snubberbeschaltungen können damit entfallen.

Zum Minimieren der Induktivität zwischen den parallelen Strompfaden sind die entsprechenden abschaltbaren Halbleiterbauelemente eines Viertelbrückenzweiges mit einer unstrukturierten Hauptelektrode auf einer gemeinsamen Stromschiene befestigt. Auf der positiven Versorgungsschiene sind die FCThs des HS-Zweiges (High Side) mit ihrer Anodenseite und auf negativen die CFCThs des LS-Zweiges (Low Side) mit ihrer Kathodenseite aufgelötet. Die Bauelemente (abschaltbare Halbleiterbauelemente, Freilaufdioden, Clamping-Kondensatoren) der parallelen Strompfade sind ungekapselt in einem gemeinsamen Gehäuse mit gutem, gegenseitigem thermischem Kontakt untergebracht. Diese Ausführungsform ermöglicht eine einfache Kühlung. Wegen der niederinduktiven Parallelschaltung ist es in diesem Fall nicht nötig, dass für jedes Halbleiterbauelement ein separater Clamping-Kondensator vorgesehen ist. Mit anderen Worten: Es gibt keine strenge Zuordnung zwischen den Kondensatoren und den Strompfaden. Diese Lockerung der Regel ist aufgrund der kleinen Induktivität zwischen den Strompfaden möglich. Entsprechend können also weniger Clamping-Kondensatoren als Leistungsschalter resp. Freilaufdioden vorgesehen sein.

Eine im oberen Leistungsbereich zentrale Schaltandordnung stellt die Brückenschaltung dar, wie sie z.B. in der nicht vorveröffentlichten Patentanmeldung EP-A- 463523 beschrieben ist.

Ein wesentlicher Aspekt der erfindungsgemässen Anordnung besteht nun darin, dass die bekannte Halbbrückenschaltung in zwei voneinander getrennte Viertelbrückenzweige aufgeteilt wird. Jede Viertelbrücke setzt sich erfindungsgemäss aus mehreren parallelen Modulen zusammen. Jedes Modul wiederum umfasst ein abschaltbares Halbleiterbauelement, eine gegenüberliegende Freilaufdiode und einen Clamping-Kondensator. Diese drei Elemente sind räumlich nahe beieinander angeordnet und niederinduktiv verbunden.

Mit den erfindungsgemässen Modulen können vorteilhafte Serieschaltungen realisiert werden. Vorallem die Kaskodeschaltung hat in dieser Hinsicht grosse Vorteile, da für die auf unterschiedlichen Potentialen liegenden Gates wegen der geringen Steuerleistung keine eigenen Versorgungseinheiten vorgesehen werden müssen. Die für die Erfindung geeignete Kaskode ist aus EP-0 260 471 bekannt.

Weitere geeignete Ausführungsformen ergeben sich unter Berücksichtigung der parallelen Anmeldung "Inverter mit Ueberstromschutz", die vom Anmelder unter Benennung des selben Erfinders am selben Tag eingereicht worden ist. Der Inhalt der parallelen Anmeldung soll hiermit als in der vorliegenden Beschreibung eingeschlossen gelten.

Aus der Gesamtheit der abhängigen Patentansprüchen ergeben sich weitere vorteilhafte Ausführungsformen.

### Kurze Beschreibung der Zeichnungen

Nachfolgend soll die Erfindung anhand von Ausführungsbeispielen und im Zusammenhang mit den Zeichnungen näher erläutert werden. Es zeigen:
- Fig. 1a,b: eine Schaltanordnung für eine Brückenschaltung, die mit separaten Modulen mit FCThs aufgebaut ist;
- Fig. 2a,b: eine Schaltanordnung für eine einfache Kühlung;
- Fig. 3: eine gemeinsame Gate-Unit mit potentialtrennendem HF-Ueberträger; und
- Fig. 4: eine Serie-Parallel-Schaltanordnung.

Die in den Zeichnungen verwendeten Bezugszeichen und deren Bedeutung sind in der Bezeichnungsliste zusammenfassend aufgelistet. Grundsätzlich sind in den Figuren gleiche Teile mit gleichen Bezugszeichen versehen.

### Wege zur Ausführung der Erfindung

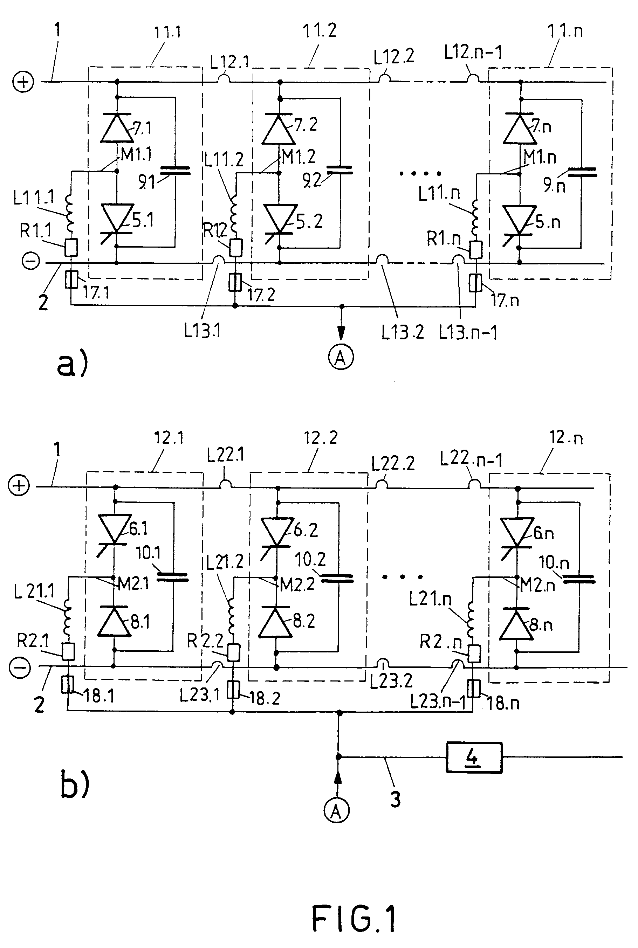

Fig. 1a,b zeigt ein erstes Ausführungsbeispiel einer erfindungsgemässen Brückenschaltung. Die Eingangsseite der Schaltung wird durch eine positive und eine negative Versorgungsleitung 1 resp. 2 gebildet. Auf der Ausgangsseite steht ein Lastanschluss 3 zur Verfügung, an welchem als Last 4 z.B. eine der drei von einem Drehstrommotor benötigten Phasen abgegeben wird.

Die in Fig. 1a,b gezeigte Halbbrücke ist aufgeteilt in zwei Viertelbrückenzweige. Der in Fig. 1b gezeigte Viertelbrückenzweig wird im folgenden als HS-Zweig (High Side), und der in Fig. 1a gezeigte als LS-Zweig (Low Side) bezeichnet. Mit dieser Notation soll angezeigt werden, ob die abschaltbaren Halbleiterbauelemente an der positiven oder an der negativen Versorgungsleitung angeschlossen sind.

Gemäss einem Kennzeichen der Erfindung wird der zu verarbeitende Gesamtstrom (d.h. der durch die Brückenschaltung insgesamt an die Last 4 abgegebene Strom) auf mehrere, parallele Strompfade aufgeteilt. Jeder Strompfad umfasst mindestens ein über ein Gate abschaltbares Halbleiterbauelement 5.1 resp. 5.2, .., 5.n, 6.1 resp. 6.2, .., 6.n, eine Freilaufdiode 7.1 resp. 7.2, .., 7.n, 8.1 resp. 8.2, .., 8.n und einen Clamping-Kondensator 9.1 resp. 9.2, .., 9.n, 10.1 resp. 10.2, .., 10.n. Die Viertelbrückenzweige sind also in eine gewisse Anzahl von LS- und HS-Module 11.1, 11.2, .., 11.n resp. 12.1, 12.2, ..., 12.n gegliedert.

Im Hinblick auf eine bessere Verständlichkeit wird im folgenden nur noch auf einen (d.h. den ersten Strompfad "·.1") Bezug genommen. Für die übrigen gilt in der Regel entsprechendes.

Im LS-Modul 11.1 ist das Halbleiterbauelement 5.1 mit seiner Kathode an die negative Versorgungsleitung 2 angeschlossen. Anodenseitig befindet sich der Mittelpunkt M1.1 (Ausgang zum Lastanschluss 3) des Moduls. Bezüglich dieses Mittelpunktes M1.1 gegenüberliegend ist die Freilaufdiode 7.1, welche mit ihrer Kathode an die positive Versorgungsleitung 1 angehängt ist. Zum Auffangen der Reverse-Recovery Spannungsspitzen ist der Clamping-Kondensator 9.1 parallel zu Halbleiterbauelement 5.1 und Freilaufdiode 7.1 angeordnet.

Die drei Bauelemente 5.1, 7.1 und 9.1 sind räumlich nahe beieinander angeordnet und mit niederinduktiven Verbindungen kontaktiert, so dass der entsprechende Freilaufpfad eine minimale Induktivität aufweist. Vorzugsweise ist das Modul 11.1 wie in der nicht vorveröffentlichten Patentanmeldung EP-A-463523 beschrieben ausgebildet.

Das HS-Modul 12.1 unterscheidet sich vom LS-Modul 11.1 dadurch, dass Halbleiterbauelement 6.1 und Freilaufdiode 8.1 in ihrer Position vertauscht sind. Hier ist also das abschaltbare Halbleiterbauelement 6.1 mit seiner Anode direkt an die positive Versorgungsleitung angeschlossen. Im übrigen gilt sinngemäss das für das LS-Modul 11.1 Gesagte.

Gemäss einer besonders vorteilhaften Ausführungsform ist zwischen dem Lastanschluss 3 und einem jedem Mittelpunkt der Stromzweige (HS- resp. LS-Module) eine kleine Induktivität L11.1, ..., L11.n, L21.1, ..., L21.n angeordnet. Diese kann gemäss der Erfindung mehrere Funktionen übernehmen.

Eine erste Aufgabe der Induktivität L11.1 besteht im Ausgleichen der transienten Stromverteilung. Da die Halbleiterbauelemente untereinander eine gewisse Parameterstreuung aufweisen und auch die Ansteuerung nicht absolut synchron sein kann, ist es unvermeidlich, dass z.B. beim Abschalten nicht alle Bauelemente gleichzeitig in den sperrenden Zustand übergehen. Vielmehr wird zwischen dem Gros der Module und einem Nachzügler eine nicht zu vernachlässigende Zeitverzögerung auftreten. In dieser Zeit konzentriert sich der Strom auf das einzige resp. die wenigen noch eingeschalteten Bauelemente.

Die Induktivität L11.1 wird nun gerade so gross gewählt, dass diese Ein- und Ausschaltdifferenzen keinen merklichen Einfluss auf die transiente Stromverteilung ausüben können. Mit anderen Worten: Ein durch eine Schaltverzögerung der genannten Art bedingter Stromanstieg wird so stark abgebremst, dass das abschaltbare Halbleiterbauelement nicht überlastet wird. Konkrete Werte lassen sich nach dieser Regel ohne weiteres ermitteln, sind doch in der praktischen Anwendung sowohl die maximal zu erwartende Zeitverzögerung als auch die auftretenden Spannungen bekannt.

Gemäss einer besonders bevorzugten Ausführungsform erfüllt die Induktivität L11.1 auch eine zweite Funktion, und zwar diejenige der Kurzschlussicherung. Wenn der Strom wegen eines Kurzschlusses stark ansteigt, dann muss dieser Fehler als erstes erkannt und dann das Halbleiterbauelement abgeschaltet werden. Sowohl die Detektion eines Kurzschlusses als auch das Abschalten brauchen eine gewisse Zeit. Ausgehend von der Grundlast (im einzelnen Strompfad) darf der Strom in dieser Zeit nicht über den maximal abschaltbaren Grenzstrom steigen.

Die Detektion des Ueberstroms findet vorzugsweise in jedem Modul separat statt. Beispielsweise können Mittel vorgesehen sein, um die an der Induktivität L11.1 anliegende Spannung zu messen. Diese ist bekanntlich proportional zur zeitlichen Aenderung des Stroms. Durch eine einfache zeitliche Integration der genannten Spannung kann somit der Strom gemessen werden.

Die Ueberstromfunktion muss natürlich so ausgelegt sein, dass sie nicht durch die Ein- resp. Ausschaltverzögerung (d.h. ungleichmässige transiente Stromverteilung) ausgelöst wird.

Die zwischen den Mittelpunkten M1.1, ..., M1.n, M2.1, ..., M2.n der parallelen Module 11.1, ..., 11.n, 12.1, ..., 12.n angeordneten Induktivitäten L11.1 etc. liegen typischerweise im Bereich von einigen »H, wenn angenommen wird, dass ein Modul 200 A schaltet und etwa 2.5 kV sperrt.

Zwischen den einzelnen Modulen soll die eingangsseitige Verbindung möglichst niederinduktiv sein. Das heisst, die Induktivitäten L12.1, L12.2, ..., L12.n-1 resp. L22.1, L22.2, ..., L22.n-1 in der positiven und die Induktivitäten L13.1, L13.2, ..., L13.n-1 resp. L23.1, L23.2, ..., L23.n-1 in der negativen Versorgungsleitung 1 resp. 2 sind so klein wie möglich gehalten.

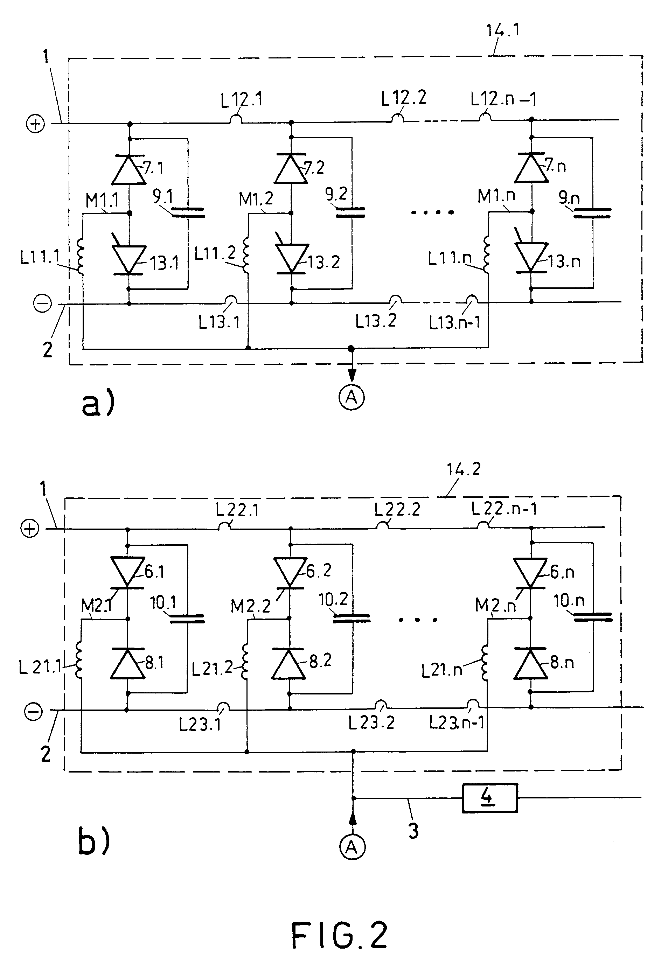

Eine Ausführungsform, welche diesbezüglich besonders vorteilhaft ist, zeigt Fig. 2a,b. Während der HS-Zweig (Fig. 2b) vom Prinzip her gleich ausgebildet ist wie in ersten Beispiel (Fig. 1b), unterscheidet sich der LS-Zweig (Fig. 2a) durch die Verwendung von komplementären abschaltbaren Halbleiterbauelementen 13.1, 13.1, ..., 13.n anstelle der gewöhnlichen (5.1, 5.2, ..., 5.n in Fig. 1a). Komplementäre Leistungsschalter zeichnen sich dadurch aus, dass das Gate anodenseitig angebracht ist.

Besonders bevorzugt werden in dieser Hinsicht die CFCThs (Complementary Field Controlled Thyristor). Das Bauelementepaar FCTh/CFCTh hat weitgehend entsprechende elektrische Parameter. Ausserdem können beide Elementtypen hart (d.h. ohne Snubber) angesteuert werden.

Der grosse Vorteil der in Fig. 2a,b gezeigten Ausführungsform liegt nun darin, dass sowohl im HS-Zweig (Fig. 2b) als auch im LS-Zweig (Fig. 2a) die parallelen Halbleiterbauelemente 6.1, 6.2, ..., 6.n resp. 13.1, 13.2, ..., 13.n mit ihrer unstrukturierten Seite (d.h. mit der Anode beim FCTh und mit der Kathode beim CFCTh) direkt auf die entsprechende Schiene der Versorgungsleitungen (1 resp. 2) aufgelötet werden können. Infolgedessen sind die Bauelemente in gutem thermischem Kontakt miteinander. Ebenso sind hier die unerwünschten Induktivitäten L12.1, L12.2, ..., L12.n-1 resp. L22.1, L22.2, ..., L22.n-1 (in der positiven) und die Induktivitäten L13.1, L13.2, ..., L13.n-1 resp. L23.1, L23.2, ..., L23.n-1 (in der negativen Versorgungsleitung 1 resp. 2) optimal klein.

Vorzugsweise sind die Bauelemente (Halbleiterbauelement, Freilaufdiode und Clamping-Kondensator) eines Viertelbrückenzweiges in einem gemeinsamen Gehäuse 14.1, 14.2 untergebracht, das Schutz gegen atmosphärische Einflüsse bietet. D.h. die einzelnen Gehäuse der LS- und HS-Module 11.1,..,11.n, resp. 12.1,..,12.n (Fig. 1a,b) entfallen zugunsten eines kostengünstigen Gehäuses 14.1 resp. 14.2 (Fig. 2a,b), welches aus einfach verarbeitbarem Blech bestehen kann.

Zum Gewährleisten einer ausgeglichenen statischen Stromverteilung in den parallelen Strompfaden kann z.B. je in Serie zu der strombegrenzenden Induktivität ein Widerstand R1.1, R1.2, ..., R1.n, R2.1, R2.2, ..., R2.n vorgesehen sein (Fig. 1a,b). Sein Wert ist so bemessen, dass bei Vollast ein Spannungsabfall von 0.1 bis 1 V, vorzugsweise 0.2 bis 0.5 V, resultiert.

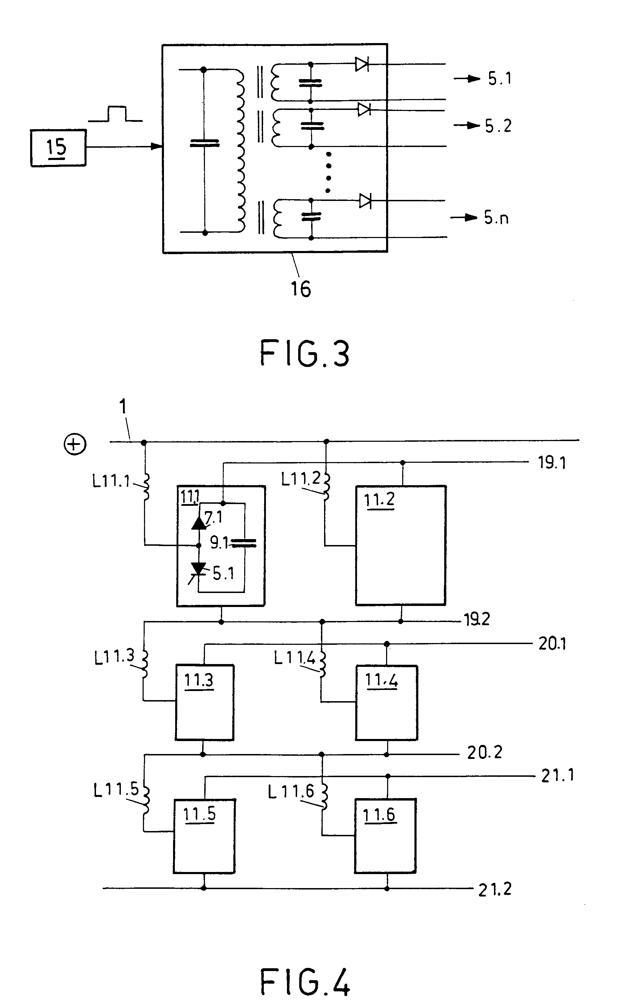

Fig. 3 zeigt eine gemeinsame Gate-Unit 15, die potentialgetrennte Gatesignale erzeugt. Am Eingang eines HF-Ueberträgers 16 wird z.B. ein Rechteckpuls angelegt, der in an sich bekannter Weise auf verschiedene Potentiale transformiert wird. Die parallelen Ausgänge führen zu den Gateanschlüssen der MOSFETs, die die abschaltbaren Halbleiterbauelemente eines Viertelbrückenzweiges in herkömmlicher Weise oder entsprechend der aus der EP-0 260 471 bekannten Kaskodeschaltung ansteuern (z.B. zu den Bauelementen 5.1, 5.2, ..., 5.n).

Die bevorzugte Kaskodeschaltung zeichnet sich durch Parallelschaltung einer Zenerdiode und eines Kondensators aus, welche zwischen dem Gate des Halbleiterbauelements einerseits und einer Elektrode eines an die Kathode angeschlossenen MOSFETs andererseits angeordnet ist.

Der HF-Ueberträger 16 kann selber zur vollen Potentialtrennung benutzt werden, oder durch eine potentialtrennende Faseroptikverbindung angesteuert sein.

Wenn die transiente Stromverteilung durch die Induktivitäten L11.1, ..., L11.n, L21.1, ..., L21.n ausgeglichen wird, dann ist es besonders einfach, die Belastung eines abschaltbaren Halbleiterbauelements zu ermitteln. Erfindungsgemäss werden für jeden Strompfad Mittel vorgesehen, die die an der jeweiligen Induktivität anliegende Spannung messen. Durch Integration der Spannung über die Zeit erhält man in bekannter Weise den fliessenden Strom (resp. den Anteil, der sich innerhalb der Integrationszeit geändert hat). Ein auf dieser Messung beruhendes Signal kann dann für die Ueberstromdetektion verwendet werden.

Als abschaltbare Halbleiterbauelemente eignen sich neben dem besonders bevorzugten FCTh resp. CFCTh im Prinzip alle schnellen, snubberfreien Schalter mit geringen Speicherzeiten (Schaltzeit < 200 ns). Dazu gehören z.B. der feinstrukturierte GTO oder - für kleinere Spannungen - der IGBT (Insulated Gate Bipolar Transistor).

Damit bei Ausfall eines der parallelgeschalteten Module nicht die ganze Brückenschaltung aussteigt, empfiehlt es sich, für jedes Modul zwischen dem Mittelpunkt und dem Lastanschluss eine Sicherung 17.1, 17.2, ..., 17.n, 18.1, 18.2, ..., 18.n (Fig. 1a,b) vorzusehen, die bei Defekt des Halbleiterbauelements durchbrennt. Aufgrund der Redundanz (Sicherheitsmarge) funktioniert dann die Brückenschaltung trotzdem noch anstandslos. Die Sicherung kann zumindest teilweise (wenn nicht ganz) zum Ausgleichen der statischen Stromverteilung dienen.

Induktivität L11.1, Widerstand R1.1 resp. Sicherung 17.1 können jeweils wahlweise im Viertelbrückenmodul oder ausserhalb davon angeordnet sein. Aus der Sicht des Anwenders ist es natürlich von Vorteil, wenn das, was er ohnehin serienmässig in seiner Schaltung vorsehen muss (z.B. strombegrenzende Induktivität etc.), bereits im einzelnen Modul integriert ist.

Fig. 4 schliesslich zeigt eine Serie-Parallel-Brückenschaltung, wie sie zum Verarbeiten hoher Spannungen geeignet ist. Einfachheitshalber sind drei Stufen mit je zwei parallelen LS-Modulen 11.1 und 11.2, 11.3 und 11.4, 11.5 und 11.6 gezeigt. Die Mittelpunkte der beiden obersten LS-Module 11.1 und 11.2 sind über die strombegrenzenden Induktivitäten L11.1 resp. L11.2 an die positive Versorgungsleitung 1 (Eingang) gehängt. Die Modulanschlüsse, an denen jeweils direkt die abschaltbaren Halbleiterbauelemente mit ihren Kathoden hängen, werden mit einer Stromschiene 19.2 (Ausgang der ersten Stufe) niederinduktiv verbunden. Ebenso werden die verbleibenden Modulanschlüsse (Kathoden der Freilaufdioden) mit einer Stromschiene 19.1 parallel geschaltet.

Die Mittelpunkte (Eingang) der nächsten Stufe (LS-Module 11.3, 11.4) werden wiederum über Induktivitäten L11.3, L11.4 an die Stromschiene 19.2 (Ausgang der vorhergehenden Stufe) gehängt. Sinngemäss zur ersten Stufe werden zwei Stromschienen 20.1, 20.2 vorgesehen.

Die dritte Stufe (LS-Module 11.5, 11.6) ist analog verschaltet. Die Stromschiene 21.2 ist dann der Ausgang der ganzen Serie-Parallel-Schaltung der Viertelbrückenmodule.

Insgesomt sind die einzelnen Zweige also so miteinander verschaltet, dass eine Serieschaltung der abschaltbaren Halbleiterbauelemente 5.1,... entsteht. Die Induktivitäten L11.1,... dienen zur Begrenzung der Stromanstiegsgeschwindigkeit sowohl in den parallelen Zweigen als auch im gesamten Seriezweig. Die Freilaufdioden 7.1,... und die Clamping-Kondensatoren 9.1,... dienen entweder zur Spannungsbegrenzung am jeweiligen Halbleiterbauelement 5.1,... (dann bleiben die Kondensatoren immer zumindest teilweise geladen) oder zur Besnubberung (dann werden die Kondensatoren während der Einschaltdauer der abschaltbaren Bauelemente entladen).

Die im vorliegenden Ausführungsbeispiel verwendeten LS-Module 11.1, ..., 11.6 können entsprechend den in Fig. 1 gezeigten ausgebildet sein. Die Freilaufdiode und der Clamping-Kondensator begrenzen in diesem Fall die Spannung sowohl bei verzögertem Einschalten als auch beim verfrühten Ausschalten der entsprechenden Elementgruppe. Diode und Kondensator können dabei sowohl als Ueberspannungsschutz (dann ist die Kapazität immer geladen) als auch als Snubber (dann wird die Kapazität periodisch entladen) genutzt werden.

Vorzugsweise wird aber das abschaltbare Halbleiterbauelement mit einer Kaskodeschaltung angesteuert. In diesem Fall gestaltet sich die Ansteuerung besonders einfach, da wegen den vernachlässigbar kleinen Steuerleistungen für die sich auf stark verschiedenen Potentialen befindenden Gates keine je eigenen Versorgungseinheiten vorzusehen sind.

Insgesamt betrachtet führen folgende Faktoren zu einer Reduktion der Kosten:
1. Verwendung von Standardkomponenten, die in allen Marktsegmenten von z.B. 200 A bis über 3kA eingesetzt werden können.
2. Es ist keine aufwendige Einspannung nötig. Es kann die billige Löttechnik an kleinen bis mittleren Chips eingesetzt werden.
3. Es ist eine einfache und wenn nötig sogar potentialgetrennte Kühlung möglich.
4. Die erfindungsgemässe Brückenschaltung kann höchste Ströme verarbeiten. Die mit der Entwicklung von leistungsstarken Komponenten verbundenen Kosten werden umgangen.
5. Durch direkten Lötkontakt zwischen Chip und Kühlkörper ergibt sich ein weit kleinerer Wärmeübergangswiderstand, als er im normalen (für den Hochstromaufbau üblichen) Druckkontaktgehäuse im Stand der Technik realisiert werden kann.
6. Es wird ein einfaches, hochwirksames Schutzkonzept verwendet.

Abschliessend kann festgehalten werden, dass mit der Erfindung ein neuer Weg beschritten worden ist zur Realisierung einer für viele Anwendungsgebiete zentralen leistungsstarken Schaltandordnung.

### Bezeichnungsliste

1 - positive Versorgungsleitung; 2 - negative Versorgungsleitung; 3 - Lastanschluss; 4 - Last; 5.1,..,5.n - abschaltbares Halbleiterbauelement; 6.1,..,6.n - abschaltbares Halbleiterbauelement; 7.1,..,7.n - Freilaufdiode; 8.1,..,8.n - Freilaufdiode; 9.1,..,9.n - Clamping-Kondensator; 10.1,..,10.n - Clamping-Kondensator; 11.1,..,11.n - LS-Modul; 12.1,..,12.n - HS-Modul; 13.1,..,13.n - komplementäres Halbleiterbauelement; 14.1, 14.2 - Gehäuse; 15 - Gate-Unit; 16 - HF-Ueberträger; 17.1,..,17.n - Sicherung; 18.1,..,18.n - Sicherung; 19.1, 19.2, 20.1, 20.2, 21.1, 21.2 - Stromschiene; L11.1,..,L11.n, L21.1,..,L21.n - Induktivität zur Begrenzung der Stromanstiegsgeschwindigkeit; L12.1, ..., L12.n-1, L13.1, ..., L13.n-1, L22.1, ..., L22.n-1, L23.1, ..., L23.n-1 - unerwünschte Induktivitäten in den Versorgungsleitungen; M1.1, ..., M1.n, M2.1, ..., M2.n - Mittelpunkte

## Patentansprüche

1. Viertelbrückenschaltung für grosse Ströme, umfassend mehrere, über jeweils ein Gate abschaltbare Halbleiterbauelemente (5.1,..,5.n,; 6.1,..,6.n) und je eine, bezüglich eines Mittelpunktes (M1.1,..,M1.n; M2.1,..,M2.n) gegenüberliegende Freilaufdiode (7.1,..,7.n; 8.1,..,8.n), so dass ein Gesamtstrom in der Viertelbrückenschaltung auf mehrere parallele Strompfade aufgeteilt ist, dadurch gekennzeichnet, dass
a) für jeden Strompfad im wesentlichen ein zugeordneter Clamping-Kondensator (9.1,..,9.n; 10.1,..,10.n) parallel zu Freilaufdiode (7.1,..,7.n; 8.1,..,8.n) und abschaltbarem Halbleiterbauelement (5.1,..,5.n,; 6.1,..,6.n) so angeordnet ist, dass der jeweilige Freilaufpfad insgesamt eine möglichst minimale Induktivität aufweist, und
b) zwischen einem Lastanschluss (3) der Viertelbrückenschaltung und jedem Mittelpunkt (M1.1,..,M1.n; M2.1,..,M2.n) der Strompfade je eine die Stromanstiegsgeschwindigkeit begrenzende Induktivität (L11.1,..,L11.n, L21.1,..,L21.n) vorgesehen ist, so dass ein durch eine Schaltverzögerung bedingter Stromstoss das abschaltbare Halbleiterbauelement (5.1,..,5.n,; 6.1,..,6.n) nicht überlastet.

2. Viertelbrückenschaltung nach Anspruch 1, dadurch gekennzeichnet, dass die die Stromanstiegsgeschwindigkeit begrenzende Induktivität (L11.1,..,L11.n, L21.1,..,L21.n) jeweils zusätzlich im Sinn einer Kurzschlusssicherung so bemessen ist, dass bei einem Kurzschluss der Strom innerhalb der durch die Detektionszeit und die Schaltverzögerung gegebenen Zeitspanne den maximal abschaltbaren Strom nicht überschreitet.

3. Viertelbrückenschaltung nach Anspruch 1, dadurch gekennzeichnet, dass die zum selben Viertelbrückenzweig gehörenden abschaltbaren Halbleiterbauelemente (5.1,..,5.n,; resp. 6.1,..,6.n) von einer bezüglich des jeweiligen Gates potentialgetrennten, gemeinsamen Gate-Unit (15) angesteuert sind.

4. Viertelbrückenschaltung nach Anspruch 1, dadurch gekennzeichnet, dass zum Ausgleichen der statischen Stromverteilung in den parallelen Strompfaden je in Serie zu der Induktivität ein Widerstand vorgesehen ist, welcher vorzugsweise zumindest teilweise durch eine Sicherung gebildet ist.

5. Viertelbrückenschaltung nach Anspruch 1, dadurch gekennzeichnet, dass die abschaltbare Halbleiterbauelemente (5.1,..,5.n,; 6.1,..,6.n) Teil einer Kaskodeschaltung sind, wobei jeweils mindestens ein MOSFET in Serie zu den abschaltbaren Halbleiterbauelementen (5.1,..,5.n,; 6.1,..,6.n) angeordnet ist, welcher MOSFET mit seinem Kanalwiderstand gleichzeitig zum Ausgleichen der statischen Stromverteilung dient.

6. Viertelbrückenschaltung nach Anspruch 1, dadurch gekennzeichnet, dass zum Detektieren der Belastung eines abschaltbaren Halbleiterbauelements Mittel vorgesehen sind, die die an der jeweiligen Induktivität (L11.1,..,L11.n, L21.1, ..,L21.n) anliegende Spannung messen.

7. Viertelbrückenschaltung nach Anspruch 1, dadurch gekennzeichnet, dass die abschaltbaren Halbleiterbauelemente (5.1,..,5.n,; resp. 6.1,..,6.n) FCThs oder CFCThs sind

8. Viertelbrückenschaltung nach Anspruch 1, dadurch gekennzeichnet, dass zum Minimieren der Induktivität (L12.1, ..., L12.n-1, L13.1, ..., L13.n-1, L22.1, ..., L22.n-1, L23.1, ..., L23.n-1) zwischen den parallelen Strompfaden die entsprechenden abschaltbaren Halbleiterbauelemente (5.1,..,5.n,; resp. 6.1,..,6.n) eines Viertelbrückenzweiges mit einer unstrukturierten Hauptelektrode auf einer gemeinsamen Stromschiene befestigt sind.

9. Viertelbrückenschaltung nach Anspruch 8, dadurch gekennzeichnet, dass die abschaltbaren Halbleiterbauelemente (5.1,..,5.n,; resp. 6.1,..,6.n), die Freilaufdioden (7.1,..,7.n; 8.1,..,8.n) und die Clamping-Kondensatoren (9.1,..,9.n; 10.1,..,10.n) der parallelen Strompfade ungekapselt in einem gemeinsamen Gehäuse mit gutem gegenseitigem thermischem Kontakt untergebracht sind.

10. Schaltanordnung, dadurch gekennzeichnet, dass mehrere Viertelbrückenschaltungen nach Anspruch 1 so miteinander verschaltet sind, dass
a) eine Serieschaltung der abschaltbaren Halbleiterbauelemente (5.1,...) entsteht,
b) die Induktivitäten (L11.1,...) zur Begrenzung der Stromanstiegsgeschwindigkeit sowohl in den parallelen Zweigen als auch im Seriezweig dienen und
c) die Freilaufdioden und die Freilaufdioden (7.1,...) und die Clamping-Kondensatoren (9.1,...) entweder zur Spannungsbegrenzung am jeweiligen Halbleiterbauelement (5.1,...) oder zur Besnubberung dienen.

## Claims

1. Quarter-bridge circuit for high currents, comprising a plurality of semiconductor components (5.1,..,5.n, [sic] ; 6.1,..,6.n) that can be turned off via a gate in each case and one freewheeling diode (7.1,..,7.n; 8.1;..,8.n) each, located opposite a midpoint (M1.1,..,M1.n; M2.1,..,M2.n), so that a total current in the quarter-bridge circuit is subdivided into a plurality of parallel current paths,
characterized in that
a) for each current path essentially one assigned clamping capacitor 10,1,..,10.n) is arranged in parallel with the freewheeling diode (7.1,..,7.n; 8.1,..,8.n) and the turnoff semiconductor component (5.1,..,5.n, [sic] ; 6.1,..,6.n) in such a way that the respective freewheeling path has as minimal an inductance as possible overall, and
b) there is provided between a load terminal (3) of the quarter-bridge circuit and each mid-point (M1.1,..,M1.n; M2.1,..,M2.n) of the current paths one inductor (L11.1,..,L11.n, L21.1,..,L21.n) each which limits the rate of current rise, so that a current rush caused by an operating delay does not overload the turnoff semiconductor component (5.1,..,5.n, [sic] ; 6.1,..,6.n).

2. Quarter-bridge circuit acording to Claim 1, characterized in that the inductor (L11.1,. .,L11.n, L21.1,..,L21.n) limiting the rate of current rise is additionally dimensioned in each case as a back-up fuse such that in the event of a short circuit the current does not exceed the maximum turnoff current within the time span given by the detection time and the operating delay.

3. Quarter-bridge circuit according to Claim 1, characterized in that the turnoff semiconductor components (5.1,..,5.n, [sic] ; 6.1,..,6.n, respectively) belonging to the same quarter-bridge arm are triggered by a common gate unit (15) that is electrically isolated with regard to the particular gate.

4. Quarter-bridge circuit according to Claim 1, characterized in that in order to balance the static current distribution in the parallel current paths a resistor is provided, for example in series in each case, which is preferably at least partially formed by a fuse.

5. Quarter-bridge circuit according to Claim 1, characterized in that the turnoff semiconductor components (5.1,..,5.n, [sic] ; 6.1,..,6.n) are part of a cascode circuit, at least one MOSFET being connected in each case in series to the turnoff semiconductor components (5.1,..,5.n, [sic] ; 6.1,..,6.n), which MOSFET simultaneously serves by means of its channel resistance to balance the static current distribution.

6. Quarter-bridge circuit according to Claim 1, characterized in that for the purpose of detecting the loading of a turnoff semiconductor component means are provided which measure the voltage present at the respective inductor (L11.1,..,L11.n, L21.1,..,L21.n).

7. Quarter-bridge circuit according to Claim 1, characterized in that the turnoff semiconductor components (5.1,..,5.n, [sic] ; 6.1,..,6.n, respectively) are FCThs or CFCThs.

8. Quarter-bridge circuit according to Claim 1, characterized in that in order to minimize the inductance (L12.1, ..., L12.n-1, L13.1, ..., L13.n-1, L22.1, ..., L22.n-1, L23.1, ..., L23.n-1) between the parallel current paths, the corresponding turnoff semiconductor components (5.1,..,5.n, [sic] ; 6.1,..,6.n, respectively) of a quarter-bridge arm are mounted with a non-structured main electrode on a common current rail.

9. Quarter-bridge circuit according to Claim 8, characterized in that the turnoff semiconductor components (5.1,..,5.n, [sic] ; 6.1,..6.n, respectively), the freewheeling diodes (7.1,..,7.n; 8.1,..,8.n) and the clamping capacitors (9.1,..,9.n; 10.1,..,10.n) of the parallel current paths are accommodated unenclosed in a common housing with good mutual thermal contact.

10. Circuit arrangement, characterized in that a plurality of quarter-bridge circuits according to Claim 1 are interconnected in such a way that
a) a series connection of the turnoff semiconductor components (5.1,...) results,
b) the inductors (L11.1,...) serve to limit the rate of current rise both in the parallel arms and in the series arm, and
c) the freewheeling diodes and the freewheeling diodes [sic] (7.1,...) and the clamping capacitors (9.1,...) serve either to limit the voltage at the respective semiconductor component (5.1,...) or as a snubber.

## Revendications

1. Montage en quart de pont pour des courants élevés comportant plusieurs composants semiconducteurs (5.1, .., 5.n ; 6.1, .., 6.n), chacun étant déclenchable par une gachette et ayant chacun une diode de roue libre (7.1, .., 7.n ; 8.1, .., 8.n) montée en opposition par rapport à un point central (M1.1, .., M1.n ; M2.1, .., M2.n), de façon à ce qu'un courant total dans le montage en quart de pont soit réparti sur plusieurs lignes de courant en parallèle, caractéristé par le fait que
a) pour chaque ligne de courant, essentiellement un condensateur de verrouillage correspondant (9.1, .., 9.n ; 10.1, .., 10.n), en parallèle avec la diode de roue libre (7.1, .., 7.n ; 8.1, .., 8.n) et le composant semiconducteur déclenchable (5.1, .., 5.n ; 6.1, .., 6.n), est implanté de telle façon que les différentes lignes de roue libre présentent globalement une inductance la plus petite possible, et
b) entre un raccordement de la charge (3) du montage en quart de pont et chaque point central (M1.1, .., M1.n ; M2.1, .., M2.n) des lignes de courant, il est à chaque fois prévu une inductance de limitation de la vitesse de croissance du courant (L11.1, .., L11.n, L21.1, .., L21.n) de telle façon qu'une pointe de courant provoquée par un retard de commutation ne surcharge pas le composant semiconducteur déclenchable (5.1, .., 5.n ; 6.1, .., 6.n).

2. Montage en quart de pont conformément à la revendication 1, caractérisé par le fait que l'inductance de limitation de la vitesse de croissance du courant (L11.1, .., L11.n, L21.1, .., L21.n) est à chaque fois calculée en plus dans le sens d'une protection contre les court-circuits de telle façon qu'en cas de court-circuit pendant le laps de temps donné du temps de détection et du retard de commutation, le courant ne dépasse pas l'intensité maximale interruptible.

3. Montage en quart de pont conforme à la revendication 1, caractérisé par le fait que les composants semiconducteurs déclenchables (respectivement 5.1, .., 5.n et 6.1, .., 6.n) faisant partie de la même branche du quart de pont sont excités par une unité de gachette (15) commune isolée galvaniquement par rapport à chacune des gachettes.

4. Montage en quart de pont conforme à la revendication 1, caractérisé par le fait que pour équilibrer la répartition statique du courant dans les lignes de courant en parallèle, il est à chaque fois prévu une résistance montée en série avec l'inductance, ladite résistance étant de préférence, au moins en partie, constituée par un fusible.

5. Montage en quart de pont conforme à la revendication 1, caractérisé par le fait que les composants semiconducteurs déclenchables (5.1, .., 5.n ; 6.1, .., 6.n) représentent une partie d'un montage en cascode dans laquelle il y a, à chaque fois, au moins un MOSFET monté en série avec les composants semiconducteurs déclenchables (5.1, .., 5.n ; 6.1, .., 6.n), ledit MOSFET servant simultanément à l'équilibrage de la répartition statique du courant à l'aide de sa résistance de canal.

6. Un montage en quart de pont conforme à la revendication 1, caractérisé par le fait que pour détecter la charge d'un composant semiconducteur déclenchable, il est prévu un dispositif mesurant la tension aux bornes de chacune des inductances (L11.1, .., L11.n ; L21.1, .., L21.n).

7. Montage en quart de pont conforme à la revendication 1, caractérisé par le fait que les composants semiconducteurs déclenchables (respectivement 5.1, .., 5.n et 6.1, .., 6.n) sont des FCTh ou des CFCTh.

8. Montage en quart de pont conforme à la revendication 1, caractérisé par le fait que pour minimiser l'inductance (L12.1, .., L12.n-1 ; L13.1, .., L13.n-1 ; L22.1, .., L22.n-1 ; L23.1, .., L23.n-1) entre les lignes de courant en parallèle, les composants semiconducteurs déclenchables correspondants (respectivement 5.1, .., 5.n et 6.1, .., 6.n) d'une branche du quart de pont sont fixés sur une barre conductrice commune avec une électrode principale non structurée.

9. Montage en quart de pont conforme à la revendication 8, caractérisé par le fait que les composants semiconducteurs déclenchables (respectivement 5.1, .., 5.n et 6.1, .., 6.n), les diodes de roue libre (7.1, .., 7.n ; 8.1, .., 8.n) et les condensateurs de verrouillage (9.1, .., 9.n ; 10.1, .., 10.n) des lignes de courant en parallèle sont logés dans un boîtier commun sans y être encapsulés et avec un bon contact thermique du côté opposé.

10. Configuration du circuit caractérisée par le fait que plusieurs montages en quart de pont conformes à la revendication 1 sont couplés entre eux de telle façon
a) qu'il existe un montage en série des composants semiconducteurs déclenchables (5.1, ...),
b) que les inductances (L11.1, ...) pour la limitation de la vitesse de croissance du courant servent aussi bien aux branches parallèles qu'à la branche en série et
c) que les diodes de roue libre (7.1, ...) et les condensateurs de verrouillage (9.1, ...) servent soit à la limitation de la tension appliquée aux différents composants semiconducteurs (5.1, ...), soit à la limitation de l'excitation.
